(19) Europäisches Patentamt
European Patent Office
Office européen des brevets

(11) **EP 4 557 620 A1**

(12) **EUROPEAN PATENT APPLICATION**
published in accordance with Art. 153(4) EPC

(43) Date of publication:
**21.05.2025 Bulletin 2025/21**

(21) Application number: **22956492.7**

(22) Date of filing: **25.08.2022**

(51) International Patent Classification (IPC):
***H03M 13/25*** (2006.01)    ***H03M 13/29*** (2006.01)

(52) Cooperative Patent Classification (CPC):
**H03M 13/25; H03M 13/29**

(86) International application number:
**PCT/JP2022/031969**

(87) International publication number:
**WO 2024/042665 (29.02.2024 Gazette 2024/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **MITSUBISHI ELECTRIC
CORPORATION
Chiyoda-ku
Tokyo 100-8310 (JP)**

(72) Inventor: **YOSHIDA, Tsuyoshi
Tokyo 100-8310 (JP)**

(74) Representative: **Plasseraud IP
104 Rue de Richelieu
CS92104
75080 Paris Cedex 02 (FR)**

(54) **ERROR CORRECTION CODING DEVICE AND ERROR CORRECTION CODING METHOD**

(57)    An error correction coding device is configured to include an exclusive OR operating unit (3) to acquire a plurality of information bit strings that are labels of respective multilevel modulation symbols from a frame in which a plurality of information bit strings that are labels of the plurality of multilevel modulation symbols are arranged, and operate an exclusive OR of a plurality of information bits that are labels of the respective multilevel modulation symbols, and a soft decision error correction coding unit (4) to generate soft decision error correction redundancy bits by performing soft decision error correction coding on a plurality of operation results of the exclusive OR by the exclusive OR operating unit (3).

FIG. 1

EP 4 557 620 A1

## Description

TECHNICAL FIELD

The present disclosure relates to an error correction coding device and an error correction coding method.

BACKGROUND ART

There is a transmission device including an error correction coding device that generates soft decision error correction redundancy bits by performing soft decision error correction coding on multilevel modulation symbols (see, for example, Non Patent Literature 1).

The bit string indicating the multilevel modulation symbol includes most significant bits corresponding to the number of dimensions, middle bits corresponding to the number of dimensions × K (K is an integer equal to or more than 1), and least significant bits corresponding to the number of dimensions. The middle bits are bits that are present between the most significant bit and the least significant bit.

The error correction coding device acquires each multilevel modulation symbol from a frame in which a plurality of multilevel modulation symbols is arranged. The error correction coding device generates soft decision error correction redundancy bits by performing soft decision error correction coding on each multilevel modulation symbol by using an information bit assigned to the least significant bit of each multilevel modulation symbol and an information bit assigned to a middle bit of each multilevel modulation symbol.

CITATION LIST

NON PATENT LITERATURE

Non Patent Literature 1: K. Sugitani et al., "Partial multilevel coding with probabilistic shaping for low-power optical transmission", Proc. OECC/PSC 2019, Paper TuB1-5.

SUMMARY OF INVENTION

TECHNICAL PROBLEM

The error correction coding device disclosed in Non Patent Literature 1 has a problem that the larger the number of middle bits of the multilevel modulation symbol and the larger the number of multilevel modulation symbols, the larger the operation amount of the soft decision error correction coding processing.

The present disclosure has been made to solve the above problem, and an object thereof is to obtain an error correction coding device capable of reducing the operation amount of soft decision error correction coding processing as compared with the error correction coding device disclosed in Non Patent Literature 1 when the number of middle bits of a multilevel modulation symbol and the number of multilevel modulation symbols each increase.

SOLUTION TO PROBLEM

An error correction coding device according to the present disclosure includes an exclusive OR operating unit to acquire a plurality of information bit strings that are labels of respective multilevel modulation symbols from a frame in which a plurality of information bit strings that are labels of the plurality of multilevel modulation symbols are arranged, and operate an exclusive OR of a plurality of information bits that are labels of the respective multilevel modulation symbols, and a soft decision error correction coding unit to generate soft decision error correction redundancy bits by performing soft decision error correction coding on a plurality of operation results of the exclusive OR by the exclusive OR operating unit.

ADVANTAGEOUS EFFECTS OF INVENTION

According to the present disclosure, when the number of middle bits of a multilevel modulation symbol and the number of multilevel modulation symbols each increase, it is possible to reduce the operation amount of soft decision error correction coding processing as compared with the error correction coding device disclosed in Non Patent Literature 1.

BRIEF DESCRIPTION OF DRAWINGS

FIG. 1 is a configuration diagram illustrating an error correction coding device according to a first embodiment.
FIG. 2 is a hardware configuration diagram illustrating hardware of the error correction coding device according to the first embodiment.
FIG. 3 is a hardware configuration diagram of a computer in a case where the error correction coding device is implemented by software, firmware, or the like.
FIG. 4 is a flowchart illustrating an error correction coding method which is a processing procedure of the error correction coding device.
FIG. 5A is an explanatory diagram illustrating an example of a first bit string provided to a probability shaping coding unit 1, and FIG. 5B is an explanatory diagram illustrating a frame generated by the probability shaping coding unit 1.
FIG. 6A is an explanatory diagram illustrating a frame output from the probability shaping coding unit 1 to a hard decision error correction coding unit 2, and FIG. 6B is an explanatory diagram illustrating a frame output from the probability shaping coding unit 1 to the hard decision error correction coding unit 2.

FIG. 7A is an explanatory diagram illustrating a frame output from the hard decision error correction coding unit 2 to an exclusive OR operating unit 3, and FIG. 7B is an explanatory diagram illustrating a set division bit output from the exclusive OR operating unit 3.

FIG. 8 is an explanatory diagram illustrating exclusive OR operation processing by the exclusive OR operating unit 3.

FIG. 9A and FIG. 9B are explanatory diagrams illustrating set division bits to be subjected to soft decision error correction coding by a soft decision error correction coding unit 4.

FIG. 10A is an explanatory diagram illustrating a frame in which hard decision error correction redundancy bits and soft decision error correction redundancy bits are stored, and FIG. 10B is an explanatory diagram illustrating a frame in which a pulse amplitude modulation symbol string including X[1][1:N3] and X[2][1:N3] is stored.

FIG. 11A is an explanatory diagram illustrating a correspondence between a signal point position and a bit string that is a label of the signal point position in a case where two 8-value pulse amplitude modulation symbols are arranged in a real part and an imaginary part, and FIG. 11B is an explanatory diagram illustrating an exclusive OR operation result of a bit string that is a label corresponding to each signal point in FIG. 11A.

## DESCRIPTION OF EMBODIMENTS

Hereinafter, in order to describe the present disclosure in more detail, modes for carrying out the present disclosure will be described with reference to the accompanying drawings.

First Embodiment

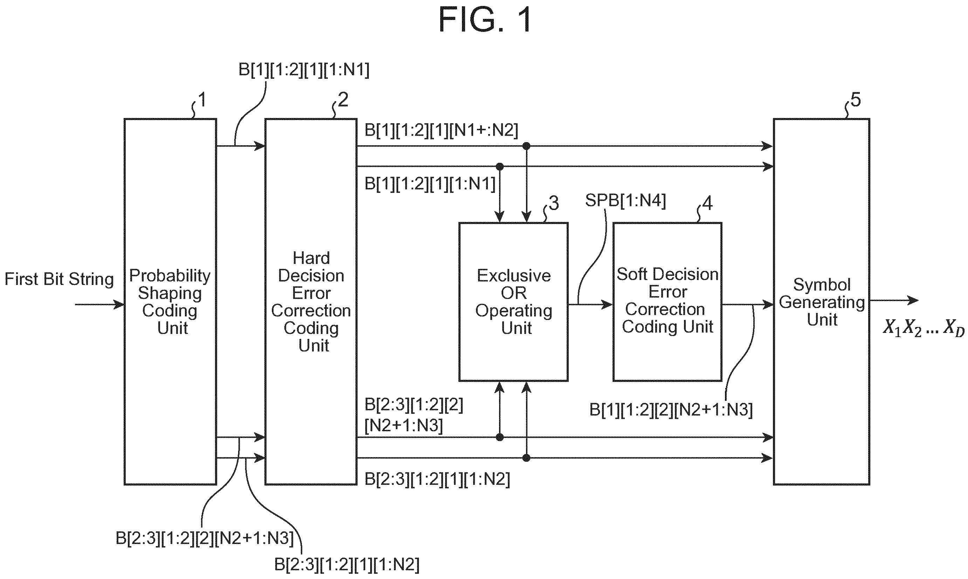

FIG. 1 is a configuration diagram illustrating an error correction coding device according to a first embodiment.

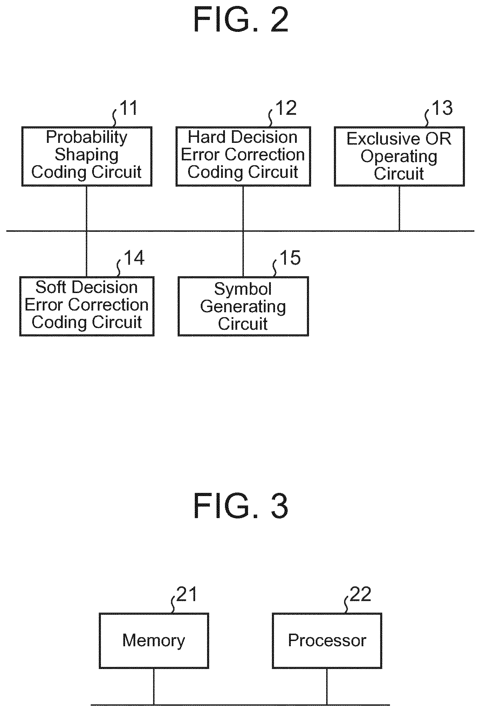

FIG. 2 is a hardware configuration diagram illustrating hardware of the error correction coding device according to the first embodiment.

The error correction coding device illustrated in FIG. 1 is mounted on a transmission device (not illustrated), for example. The error correction coding device illustrated in FIG. 1 includes a probability shaping coding unit 1, a hard decision error correction coding unit 2, an exclusive OR operating unit 3, a soft decision error correction coding unit 4, and a symbol generating unit 5. Since the transmission device (not illustrated) includes the error correction coding device illustrated in FIG. 1, the reception device (not illustrated) can correct, for example, a bit error occurred in the communication path.

The probability shaping coding unit 1 is implemented by, for example, a probability shaping coding circuit 11 illustrated in FIG. 2.

A first bit string to be communicated is provided from the outside to the probability shaping coding unit 1.

The probability shaping coding unit 1 performs probability shaping coding on the first bit string. Since the probability shaping coding unit 1 performs the probability shaping coding, when the first bit string is converted into a multilevel modulation symbol by the subsequent processing, the occurrence probability of a signal point is biased, and communication quality is improved.

The probability shaping coding unit 1 uses a second bit string, which is the first bit string after the probability shaping coding, as the information bit string, and outputs a frame in which a plurality of information bit strings is arranged to the hard decision error correction coding unit 2.

The hard decision error correction coding unit 2 is implemented by, for example, a hard decision error correction coding circuit 12 illustrated in FIG. 2.

The hard decision error correction coding unit 2 acquires a frame from the probability shaping coding unit 1.

The hard decision error correction coding unit 2 acquires a plurality of information bit strings from the frame. The second bit string, which is a label of the multilevel modulation symbol, includes a most significant bit (hereinafter referred to as "MSB") corresponding to the number of dimensions D, middle bits (hereinafter referred to as "SSB") corresponding to the number of dimensions $D \times K$, and a least significant bit (hereinafter referred to as "LSB") corresponding to the number of dimensions D. The SSBs are bits that are present between the MSB and the LSB. Unless hard decision error correction redundancy bits and soft decision error correction redundancy bits are included, a complete label cannot be obtained. In such a case, the second bit string is part of the label of the multilevel modulation symbol. D indicates the number of dimensions of each of a plurality of bits included in the multilevel modulation symbol. D is an integer equal to or more than 1. K is an integer equal to or more than 0. When K = 0, M = 2, and in this case, the second bit string includes an MSB and an LSB and does not include the SSBs.

The hard decision error correction coding unit 2 generates hard decision error correction redundancy bits by performing hard decision error correction coding on a plurality of acquired information bits.

The hard decision error correction coding unit 2 stores the hard decision error correction redundancy bits in a hard decision error correction redundancy bit storage area in the frame.

The hard decision error correction coding unit 2 outputs the frame after the hard decision error correction redundancy bit is stored to each of the exclusive OR operating unit 3 and the symbol generating unit 5.

The exclusive OR operating unit 3 is implemented by, for example, an exclusive OR operating circuit 13 illustrated in FIG. 2.

The exclusive OR operating unit 3 acquires the frame from the hard decision error correction coding unit 2.

The exclusive OR operating unit 3 acquires a plurality of information bit strings that are labels of respective multilevel modulation symbols from the frame, and operates the exclusive OR of the plurality of information bits.

The exclusive OR operating unit 3 outputs a set division bit indicating an operation result of each exclusive OR to the soft decision error correction coding unit 4.

The soft decision error correction coding unit 4 is implemented by, for example, a soft decision error correction coding circuit 14 illustrated in FIG. 2.

The soft decision error correction coding unit 4 acquires a plurality of set division bits from the exclusive OR operating unit 3.

The soft decision error correction coding unit 4 generates soft decision error correction redundancy bits by performing soft decision error correction coding on the operation result of the exclusive OR indicated by the plurality of set division bits.

The soft decision error correction coding unit 4 outputs the soft decision error correction redundancy bits to the symbol generating unit 5.

The symbol generating unit 5 is implemented by, for example, a symbol generating circuit 15 illustrated in FIG. 2.

The symbol generating unit 5 acquires a frame from the hard decision error correction coding unit 2 and acquires the soft decision error correction redundancy bits from the soft decision error correction coding unit 4.

The symbol generating unit 5 acquires the second bit string from the frame, and generates a plurality of pulse amplitude modulation symbols from the second bit string, the hard decision error correction redundancy bits, and the soft decision error correction redundancy bits. The second bit string is a part of the label of each multilevel modulation symbol or the entire label of each multilevel modulation symbol.

The symbol generating unit 5 outputs a communication symbol sequence in which a plurality of pulse amplitude modulation symbols is arranged to a reception device (not illustrated) via a communication path (not illustrated).

In FIG. 1, it is assumed that each of the probability shaping coding unit 1, the hard decision error correction coding unit 2, the exclusive OR operating unit 3, the soft decision error correction coding unit 4, and the symbol generating unit 5, which are components of the error correction coding device, is implemented by dedicated hardware as illustrated in FIG. 2. That is, it is assumed that the error correction coding device is implemented by the probability shaping coding circuit 11, the hard decision error correction coding circuit 12, the exclusive OR operating circuit 13, the soft decision error correction coding circuit 14, and the symbol generating circuit 15.

Each of the probability shaping coding circuit 11, the hard decision error correction coding circuit 12, the exclusive OR operating circuit 13, the soft decision error correction coding circuit 14, and the symbol generating circuit 15 corresponds to, for example, a single circuit, a composite circuit, a programmed processor, a parallel-programmed processor, an application specific integrated circuit (ASIC), a field-programmable gate array (FPGA), or a combination thereof.

The components of the error correction coding device are not limited to those implemented by dedicated hardware, and the error correction coding device may be implemented by software, firmware, or a combination of software and firmware.

The software or firmware is stored in a memory of the computer as a program. The computer means hardware that executes a program, and corresponds to, for example, a central processing unit (CPU), a graphics processing unit (GPU), a central processing unit, a processing unit, an arithmetic unit, a microprocessor, a microcomputer, a processor, or a digital signal processor (DSP).

FIG. 3 is a hardware configuration diagram of a computer in a case where the error correction coding device is implemented by software, firmware, or the like.

In a case where the error correction coding device is implemented by software, firmware, or the like, a program for causing a computer to execute respective processing procedures in the probability shaping coding unit 1, the hard decision error correction coding unit 2, the exclusive OR operating unit 3, the soft decision error correction coding unit 4, and the symbol generating unit 5 is stored in the memory 21. Then, a processor 22 of the computer executes the program stored in the memory 21.

Furthermore, FIG. 2 illustrates an example in which each of the components of the error correction coding device is implemented by dedicated hardware, and FIG. 3 illustrates an example in which the error correction coding device is implemented by software, firmware, or the like. However, this is merely an example, and some components in the error correction coding device may be implemented by dedicated hardware, and the remaining components may be implemented by software, firmware, or the like.

Next, an operation of the error correction coding device illustrated in FIG. 1 will be described.

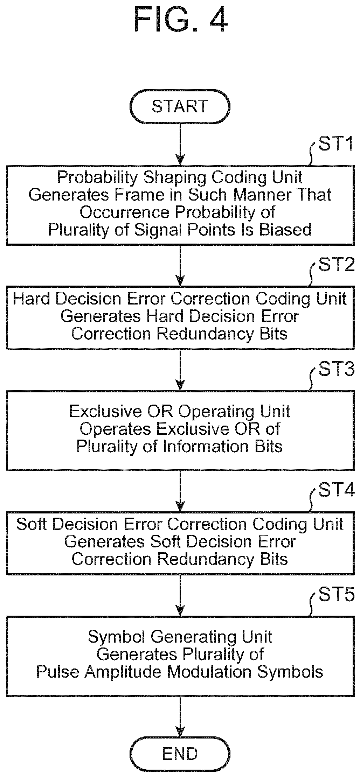

FIG. 4 is a flowchart illustrating an error correction coding method which is a processing procedure of the error correction coding device.

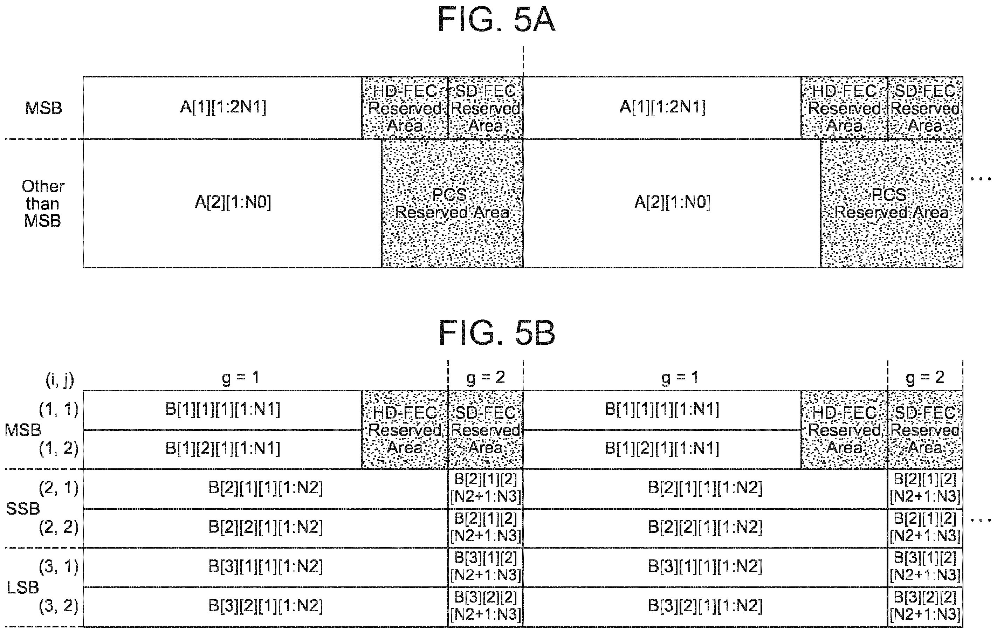

The probability shaping coding unit 1 acquires a first bit string to be communicated as illustrated in FIG. 5A from the outside.

FIG. 5A is an explanatory diagram illustrating an example of the first bit string provided to the probability shaping coding unit 1.

In the first bit string, a plurality of frames is arranged. Each frame is divided into an MSB and a portion other than the MSB.

Each of A[1][1:2N1] assigned to the MSB and A [2][1:N0] assigned to other than the MSB is an information bit. Each of N1 and N0 is an integer equal to or more than 1.

[1:2N1] is a symbol that means from the first column to the (2 × N1)-th column. [1:N0] is a symbol meaning from the first column to the N0-th column.

An HD-FEC reserved area assigned to the MSB is the hard decision error correction redundancy bit storage area and stores a first dummy bit.

An SD-FEC reserved area assigned to the MSB is a soft decision error correction redundancy bit storage area and stores a second dummy bit.

A probabilistic constellation shaping (PCS) reserved area assigned other than the MSB is an area for storing bits increased by probability shaping coding, and stores a third dummy bit.

The probability shaping coding unit 1 performs probability shaping coding on the first bit string to be communicated.

That is, the probability shaping coding unit 1 generates a frame in such a manner that the occurrence probability of the plurality of signal points in pulse amplitude modulation symbols $X_j$ (j = 1, ..., D) generated by the symbol generating unit 5 is biased by performing the probability shaping coding on the first bit string (step ST1 in FIG. 4).

The probability shaping coding unit 1 outputs a frame in which a plurality of second bit strings, which are the first bit strings after the probability shaping coding, are arranged to the hard decision error correction coding unit 2.

FIG. 5B is an explanatory diagram illustrating the frame generated by the probability shaping coding unit 1.

The frame generated by the probability shaping coding unit 1 has a group "1" (g = 1) and a group "2" (g = 2). The group "1" is a first group and the group "2" is a second group.

The group "1" includes a multilevel modulation symbol in which neither the first dummy bit nor the second dummy bit is included in the MSB or a label of the multilevel modulation symbol, and a multilevel modulation symbol in which the first dummy bit is included in the MSB or a label of the multilevel modulation symbol.

The group "2" is a group including the SD-FEC reserved area assigned to the MSB. That is, the group "2" includes the multilevel modulation symbol in which the second dummy bit is included in the MSB or a label of the multilevel modulation symbol.

In the example of FIG. 5, D = 2. j is a dimension index indicating a dimension, j = 1 indicates a first dimension, and j = 2 indicates a second dimension.

The number of bits of the D-dimensional multilevel modulation symbol is D × M. M is an integer equal to or more than 2. In the example of FIG. 5, M = 3, and the number of bits of the D-dimensional multilevel modulation symbol is 6 (= 2 × 3). i is a bit sequence index, and since M = 3 in the example of FIG. 5, i = 1, 2, and 3.

The bits of the multilevel modulation symbol are represented as B[i][j][g][c]. g is a group index, and c is a column index. c = [1:N1] means the first to N1-th columns.

As illustrated in FIG. 5B, the probability shaping coding unit 1 assigns A[1][1:2N1] assigned to the MSB in FIG. 5A to B[1][1][1][1:N1] in the first dimension and B[1][2][1][1:N1] in the second dimension.

Specifically, for example, the probability shaping coding unit 1 assigns A[1][1] to the first dimension (i, j) = (1, 1) in the first column of the MSB as B[1][1][1][1], and assigns A[1][2] to the second dimension (i, j) = (1, 2) in the first column of the MSB as B[1][2][1][1].

In addition, for example, the probability shaping coding unit 1 assigns A[1][3] to the first dimension (i, j) = (1, 1) in the second column of the MSB as B[1][1][1][2], and assigns A[1][4] to the second dimension (i, j) = (1, 2) in the second column of the MSB as B[1][2][1][2].

In FIG. 5B, the probability shaping coding unit 1 converts A[2][1:N0] assigned other than the MSB into 4 × N3 bits subjected to probability shaping. N3 is an integer equal to or more than 1.

For example, the probability shaping coding unit 1 assigns B[2][1][1][1:N2] to the first dimension (i, j) = (2, 1) of the SSB in the group "1", and assigns B[2][1][2][N2 + 1:N3] to the first dimension (i, j) = (2, 1) of the SSB in the group "2".

For example, the probability shaping coding unit 1 assigns B[2][2][1][1:N2] to the second dimension (i, j) = (2, 2) of the SSB in the group "1", and assigns B[2][1][2] [N2 + 1:N3] to the second dimension (i, j) = (2, 2) of the SSB in the group "2".

For example, the probability shaping coding unit 1 assigns B[3][1][1][1:N2] to the first dimension (i, j) = (3, 1) of the LSB in the group "1", and assigns B[3][1][2][N2 + 1:N3] to the first dimension (i, j) = (3, 1) of the LSB in the group "2".

For example, the probability shaping coding unit 1 assigns B[3][2][1][1:N2] to the second dimension (i, j) = (3, 2) of the LSB in the group "1", and assigns B[3][2][2] [N2 + 1:N3] to the second dimension (i, j) = (3, 2) of the LSB in the group "2".

The first dummy bit is stored in the HD-FEC reserved area assigned to the MSB, and the second dummy bit is stored in the SD-FEC reserved area assigned to the MSB.

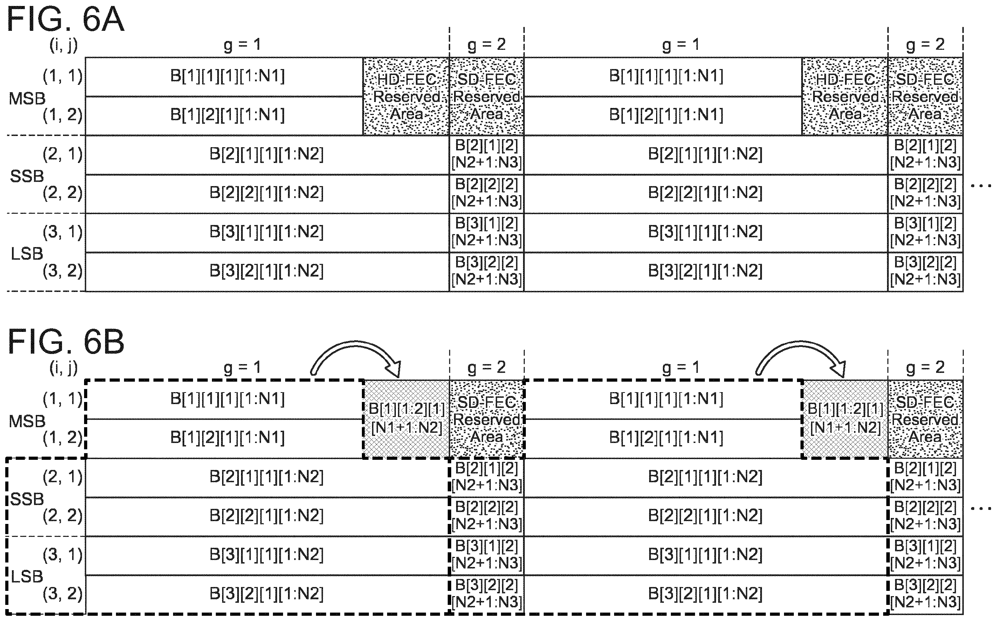

The hard decision error correction coding unit 2 acquires a frame as illustrated in FIG. 6A from the probability shaping coding unit 1.

FIG. 6A is an explanatory diagram illustrating a frame output from the probability shaping coding unit 1 to the hard decision error correction coding unit 2.

The hard decision error correction coding unit 2 acquires a plurality of information bits that is a part of labels of a plurality of multilevel modulation symbols from the frame.

Specifically, the hard decision error correction coding unit 2 acquires each of B[1][1][1][c], B[1][2][1][c], B[2][1][1][c], B[2][2][1][c], B[3][1][1][c], and B[3][2][1][c] as the $D \times M$ information bits included in the multilevel modulation symbol arranged in the c-th column (c = 1, ..., N2). However, the hard decision error correction coding unit 2 does not acquire the first dummy bit stored in the HD-FEC reserved area.

Further, the hard decision error correction coding unit 2 acquires B[2][1][2][c], B[2][2][2][c], B[3][1][2][c], and B[3][2][2][c] as $D \times (M - 1)$ information bits included in the multilevel modulation symbol arranged in the c-th column (c = N2 + 1, ..., N3).

After acquiring the $D \times M$ information bits and the like included in the multilevel modulation symbol arranged in the c-th column (c = 1, ..., N2), the hard decision error correction coding unit 2 sets the information bits included in a portion surrounded by a broken line to the HD-FEC information bits as illustrated in FIG. 6B. The HD-FEC information bits are bits to be subjected to hard decision error correction coding.

The information bits included in the portion surrounded by the broken line are B[2:3][1:2][2][N2 + 1:N3], B[1][1:2][1][1:N1], and B[2:3][1:2][1][1:N2].

The hard decision error correction coding unit 2 generates hard decision error correction redundancy bits by performing the hard decision error correction coding on the HD-FEC information bits (step ST2 in FIG. 4). The hard decision error correction coding processing itself is a known technique, and thus detailed description thereof will be omitted.

As the hard decision error correction code used in the hard decision error correction coding process, a known code such as a BCH code, a Staircase code, or a Zipper code can be used. The BCH code is disclosed in, for example, "R. Bose and D. Ray-Chaudhuri, "On a class of error correcting binary group codes," Information and Control, vol. 3, no. 1, pp. 68-79, March 1960".

The Staircase code is disclosed in, for example, "B.P. Smith et al., "Staircase codes:FEC for 100 Gb/s OTN," J. Lightw. Technol., vol. 30, no. 1, pp. 110-117, Jan. 2012, doi: 10.1109/JLT. 2011.2175479".

The Zipper code is disclosed in, for example, "A.Y. Sukmadji et al., "Zipper codes: Spatially-coupled product-like codes with iterative algebraic decoding," Canadian Workshop on Information Theory (CWIT), Hamilton, ON, Canada, June 2019, pp. 1-6, doi: 10.1109/CWIT. 2019.8929906".

As illustrated in FIG. 6B, the hard decision error correction coding unit 2 stores the generated hard decision error correction redundancy bits as B[1][1:2][1][N1 + 1:N2] in the HD-FEC reserved area assigned to the MSB. That is, the hard decision error correction coding unit 2 stores the hard decision error correction redundancy bits in the HD-FEC reserved area instead of the first dummy data stored in the HD-FEC reserved area.

FIG. 6B is an explanatory diagram illustrating a frame in which the hard decision error correction redundancy bits are stored in the HD-FEC reserved area.

The hard decision error correction coding unit 2 outputs the frame after the hard decision error correction redundancy bit is stored to each of the exclusive OR operating unit 3 and the symbol generating unit 5.

The hard decision error correction coding unit 2 may rearrange the bit positions after performing the hard decision error correction coding on the HD-FEC information bits. By rearranging the bit positions, it is possible to reduce the influence of continuous bit errors occurring in the communication path before decoding.

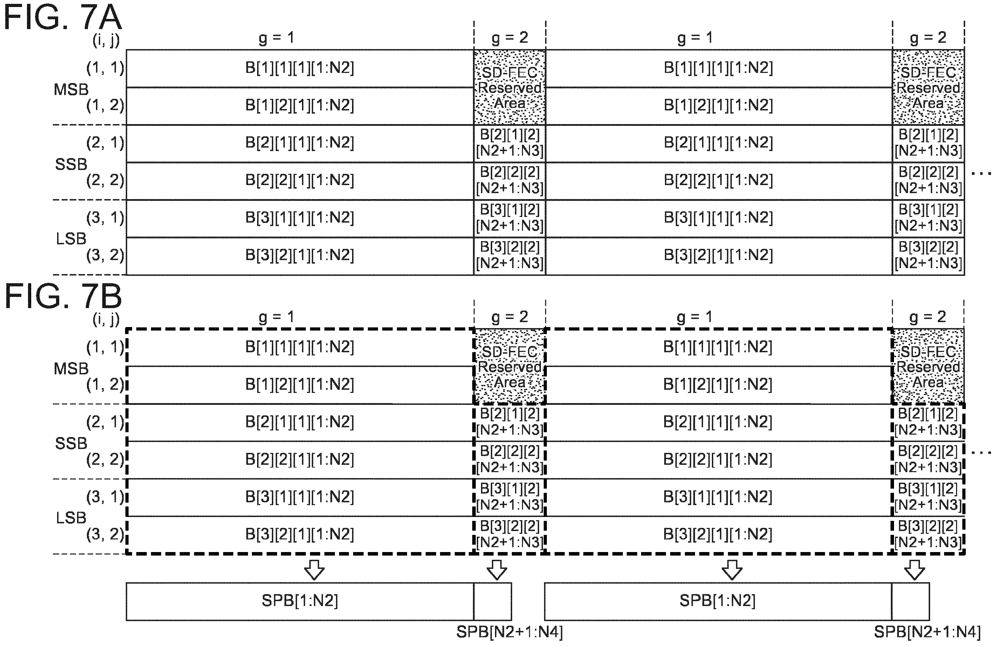

As illustrated in FIG. 7A, the exclusive OR operating unit 3 acquires the frame after the hard decision error correction redundancy bit is stored from the hard decision error correction coding unit 2.

FIG. 7A is an explanatory diagram illustrating the frame output from the hard decision error correction coding unit 2 to the exclusive OR operating unit 3. The frame illustrated in FIG. 7A is the same as the frame illustrated in FIG. 6B.

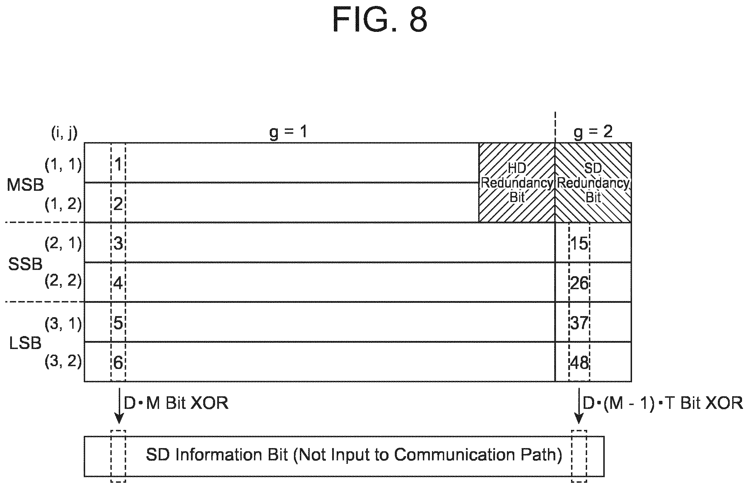

FIG. 8 is an explanatory diagram illustrating exclusive OR operation processing by the exclusive OR operating unit 3.

The exclusive OR operating unit 3 acquires a plurality of information bits that is a part of the label of each multilevel modulation symbol from the frame.

Specifically, as illustrated in FIG. 8, the exclusive OR operating unit 3 acquires each of B[1][1][1][c], B[1][2][1][c], B[2][1][1][c], B[2][2][1][c], B[3][1][1][c], and B[3][2][1][c] as $D \times M$ information bits which are arranged in the c-th column (c = 1, ..., N2) and are labels of the multilevel modulation symbols from the frame of the group "1".

"123456" illustrated in FIG. 8 indicates the order of bits from (i, j) = (1, 1) to (i, j) = (3, 2), and does not indicate a value stored in B[1][1][1][c] or the like. A value stored in B[1][1][1][c] or the like is "0" or "1".

From the frame of the group "2", the exclusive OR operating unit 3 acquires $D \times (M - 1)$ information bits which are labels of multilevel modulation symbols. T is an integer equal to or more than 1 set in such a manner that $D \times (M - 1) \times T$ is an integer.

In a case of T = 2, as illustrated in FIG. 8, the exclusive OR operating unit 3 acquires each of B[2][1][2][c], B[2][2][2][c:c], B[3][1][2][c] and B[3][2][2][c] as $D \times (M - 1)$ information bits arranged in the c-th column (c = N2 + 1, ..., N3) from the frame of the group "2".

Further, the exclusive OR operating unit 3 acquires B[2][1][2][c + 1], B[2][2][2][c + 1], B[3][1][2][c + 1], and B[3][2][2][c + 1] as $D \times (M - 1)$ information bits arranged in the (c + 1)-th column (c = N2 + 1, ..., N3).

"12345678" illustrated in FIG. 8 indicates the order of bits from the first dimension of (i, j) = (2, 1) to the second dimension of (i, j) = (3, 2), and does not indicate a value stored in B[2][1][2][c + 1] or the like. A value stored in B[2][1][2][c + 1] or the like is "0" or "1".

As illustrated in FIG. 8, when the exclusive OR operating unit 3 acquires each of the bit strings of $D \times M$ information bits as N2 bit strings from the frame of the group "1", the exclusive OR operating unit 3 operates the exclusive OR of the D × M information bits included in each of the bit strings (step ST3 in FIG. 4). However, the hard decision error correction redundancy bits included in the HD-FEC reserved area are not included in the operation target of the exclusive OR.

Further, as illustrated in FIG. 8, when the exclusive OR operating unit 3 acquires the bit strings of D × (M - 1) × T information bits as (N3 - N2)/T bit strings from the frame of the group "2", the exclusive OR operating unit 3 operates the exclusive OR of the D × (M - 1) × T information bits included in each of the bit strings (step ST3 in FIG. 4).

As illustrated in FIG. 7B, the exclusive OR operating unit 3 outputs the set division bits indicating the operation result of the exclusive OR for each of the D × M information bits acquired from the frame of the group "1" to the soft decision error correction coding unit 4 as SPB [1:N2].

As illustrated in FIG. 7B, the exclusive OR operating unit 3 outputs the set division bits indicating the operation result of the exclusive OR for each of the D × (M - 1) × T information bits acquired from the frame of the group "2" to the soft decision error correction coding unit 4 as SPB[N2 + 1:N4]. N4 is an integer equal to or more than 1, and N4 ≤ N3.

FIG. 7B is an explanatory diagram illustrating set division bits output from the exclusive OR operating unit 3.

The operation amount of the exclusive OR by the exclusive OR operating unit 3 is negligibly small as compared with the operation amount of the soft decision error correction coding processing by the soft decision error correction coding unit 4.

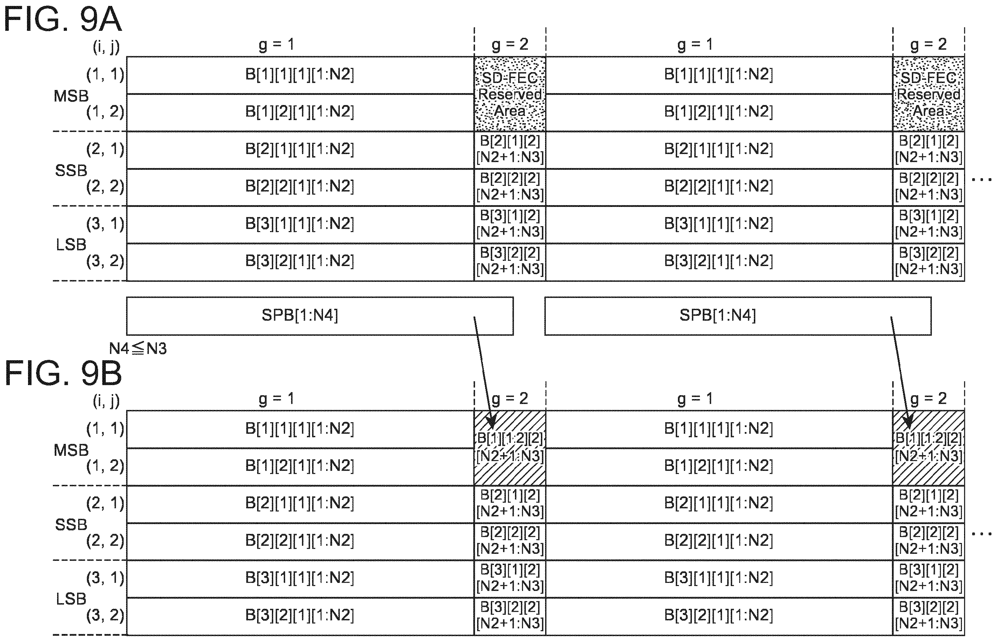

As illustrated in FIG. 9, the soft decision error correction coding unit 4 acquires SPB[1:N4] including SPB[1:N2] and SPB[N2 + 1:N4] from the exclusive OR operating unit 3.

The soft decision error correction coding unit 4 generates soft decision error correction redundancy bits by performing soft decision error correction coding on the N4 set division bits included in SPB[1:N4] (step ST4 in FIG. 4). The soft decision error correction coding processing itself is a known technique, and thus detailed description thereof will be omitted.

As illustrated in FIG. 9, the soft decision error correction coding unit 4 stores the soft decision error correction redundancy bits as B[1][1:2][2][N2 + 1:N3] in the SD-FEC reserved area assigned to the MSB. That is, the soft decision error correction coding unit 4 stores the soft decision error correction redundancy bit in the SD-FEC reserved area instead of the second dummy data stored in the SD-FEC reserved area.

The soft decision error correction coding unit 4 outputs the soft decision error correction redundancy bits to the symbol generating unit 5.

FIG. 9 is an explanatory diagram illustrating set division bits to be subjected to the soft decision error correction coding by the soft decision error correction coding unit 4.

One of targets of the soft decision error correction coding processing by the error correction coding device disclosed in Non Patent Literature 1 is all information bits assigned to the LSB of the multilevel modulation symbol and information bits assigned to the SSB of the multilevel modulation symbol of the group 2. In the example of FIG. 9, the targets of the soft decision error correction coding processing are N3 symbols for two information bits of the LSB and N3 - N2 symbols for two information bits of the SSB.

Therefore, in the example of FIG. 9, the error correction coding device disclosed in Non Patent Literature 1 performs the soft decision error correction coding on 2 × N3 + 2 × (N3 - N2) bits.

The number of targets of the soft decision error correction coding processing by the error correction coding device illustrated in FIG. 1 is one. In the example of FIG. 9, the targets of the soft decision error correction coding processing are N4 bits.

$$N4 \leq N3.$$

Therefore, the operation amount of the soft decision error correction coding processing by the error correction coding device illustrated in FIG. 1 is smaller by (2 × N3 + 2 × (N3 - N2) - N4) bits than the operation amount of the soft decision error correction coding processing by the error correction coding device disclosed in Non Patent Literature 1. In the targets of the soft decision coding processing of the pulse amplitude modulation symbols of the D-dimensional 2^M value, it is D × N3 + D × (M - 2) × (N3 - N2) in the case of the error correction coding device disclosed in Non Patent Literature 1, and it is N4 in the case of the error correction coding device illustrated in FIG. 1. Therefore, the error correction coding device illustrated in FIG. 1 has a smaller operation amount than 1/D as compared to the error correction coding device disclosed in Non Patent Literature 1, and the larger each of D, M, and T is, the higher the effect is.

The symbol generating unit 5 acquires the frame from the hard decision error correction coding unit 2 and acquires the soft decision error correction redundancy bits from the soft decision error correction coding unit 4.

Instead of acquiring the frame from the hard decision error correction coding unit 2, the symbol generating unit 5 may acquire the frame after storing the soft decision error correction redundancy bits from the soft decision error correction coding unit 4.

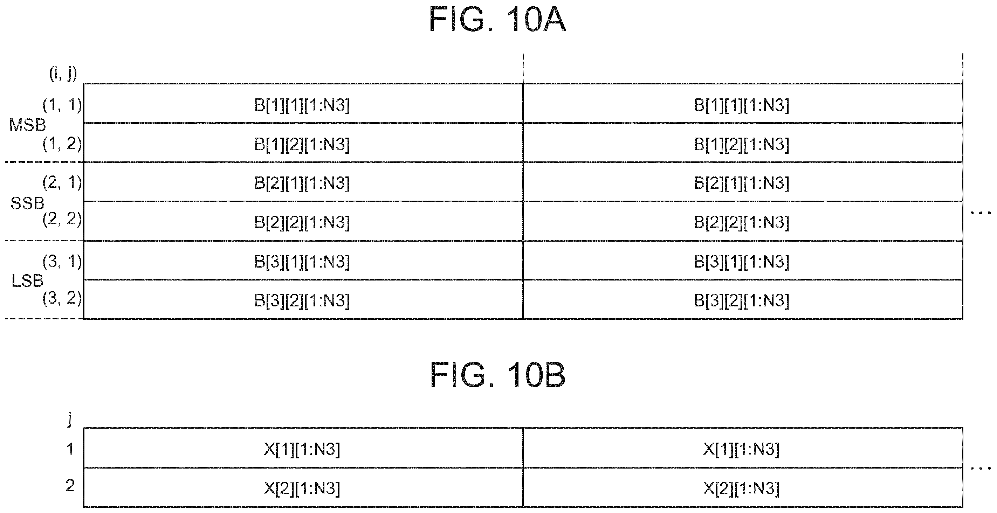

FIG. 10A is an explanatory diagram illustrating a frame in which the hard decision error correction redundancy bits and the soft decision error correction redundancy bits are stored.

The hard decision error correction redundancy bits are stored in the HD-FEC reserved area in the frame illustrated in FIG. 10A, and the soft decision error correction redundancy bits are stored in the SD-FEC reserved area.

However, FIG. 10A does not clearly illustrate each of the HD-FEC reserved area and the SD-FEC reserved area.

Furthermore, in FIG. 10A, dividing into the group "1" and the group "2" is not performed.

For example, in the case of D = 2, the symbol generating unit 5 acquires each of B[1][1][c], B[2][1][c], and B[3][1][c] as M information bits which are arranged in the c-th column (c = 1, ..., N3) of the first dimension and are labels of the multilevel modulation symbols from the above frame. Since dividing into the groups is not performed, the group index g of the above information bits is omitted.

Further, the symbol generating unit 5 acquires each of B[1][2][c], B[2][2][c], and B[3][2][c] as M information bits arranged in the c-th column (c = 1, ..., N3) of the second dimension from the above frame.

In the case of D = 2, as illustrated in FIG. 10B, the symbol generating unit 5 generates the pulse amplitude modulation symbols $X_j$ (j = 1, ..., D) from B[1][1][c], B[2][1][c], and B[3][1][c], which are M information bits in the first dimension, and stores the pulse amplitude modulation symbols $X_j$ in the area of X[1][1:N3] (step ST5 in FIG. 4).

In addition, as illustrated in FIG. 10B, the symbol generating unit 5 generates the pulse amplitude modulation symbols $X_j$ from B[1][2][c], B[2][2][c], and B[3][2][c], which are M information bits of the second dimension, and stores the pulse amplitude modulation symbols $X_j$ in the area of X[2][1:N3] (step ST5 in FIG. 4).

FIG. 10B is an explanatory diagram illustrating a frame storing a pulse amplitude modulation symbol string including X[1][1:N3] and X[2][1:N3].

The symbol generating unit 5 outputs a communication symbol sequence in which D pulse amplitude modulation symbols $X_j$ including X[1][1:N3] and X[2][1:N3] are arranged to a reception device (not illustrated) via a communication path (not illustrated).

Here, in a case where the pulse amplitude modulation symbols having a value equal to or less than the M-th power of 2 per dimension is generated, the symbol generating unit 5 can generate the pulse amplitude modulation symbols $X_j$ (j = 1, ..., D) by performing reflected binary gray coding on the D $\times$ M bits in such a manner that the bit difference between adjacent symbols is only one bit.

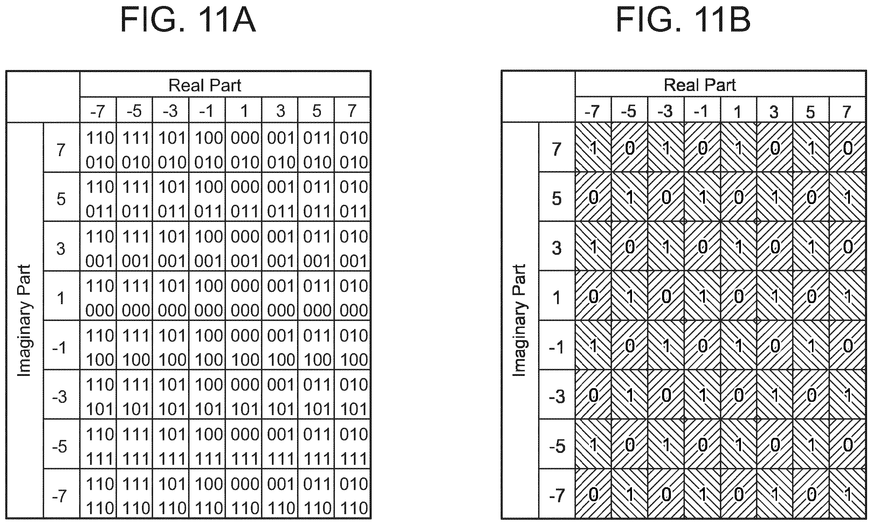

When generating one pulse amplitude modulation symbol, for example, in a case where M = 3 and the Euclidean distance between signal points is 2, the symbol generating unit 5 can assign a bit "000" to a symbol "1", a bit "001" to a symbol "3", a bit "011" to a symbol "5", and a bit "010" to a symbol "7" as illustrated in FIG. 11A. In addition, the symbol generating unit 5 can assign a bit "100" to a symbol "-1", a bit "101" to a symbol "-3", a bit "111" to a symbol "-5", and a bit "110" to a symbol "-7". In addition, the symbol generating unit 5 can assign "0" or "1" to the symbol "-7", the symbol "-5", the symbol "-3", the symbol "-1", the symbol "1", the symbol "3", the symbol "5", or the symbol "7" as illustrated in FIG. 11B by performing exclusive OR on the bits.

FIG. 11A is an explanatory diagram illustrating a correspondence between a signal point position and a bit string that is a label of the signal point position in a case where two 8-value pulse amplitude modulation symbols are arranged in a real part and an imaginary part.

FIG. 11B is an explanatory diagram illustrating an exclusive OR operation result of a bit string which is a label corresponding to each signal point in FIG. 11A. For each signal point, the set division bit takes a value as illustrated in FIG. 11B, and can be divided into two sets of "0" side and "1" side.

In the first embodiment described above, the error correction coding device is configured to include the exclusive OR operating unit 3 to acquire a plurality of information bit strings that are labels of respective multilevel modulation symbols from a frame in which a plurality of information bit strings that are labels of the plurality of multilevel modulation symbols are arranged, and operate an exclusive OR of a plurality of information bits that are labels of the respective multilevel modulation symbols, and the soft decision error correction coding unit 4 to generate soft decision error correction redundancy bits by performing soft decision error correction coding on a plurality of operation results of the exclusive OR by the exclusive OR operating unit 3. Therefore, when the number of middle bits of a multilevel modulation symbol and the number of multilevel modulation symbols each increase, the error correction coding device can reduce the operation amount of soft decision error correction coding processing as compared with the error correction coding device disclosed in Non Patent Literature 1.

Further, in the first embodiment, the error correction coding device is configured to include the hard decision error correction coding unit 2 to acquire a plurality of information bits that are labels of respective multilevel modulation symbols from the frame and generate hard decision error correction redundancy bits by performing hard decision error correction coding on the plurality of information bits, and the symbol generating unit 5 to generate a plurality of pulse amplitude modulation symbols from a part of the labels of the respective multilevel modulation symbols or all of the labels of the respective multilevel modulation symbols, the hard decision error correction redundancy bits, and the soft decision error correction redundancy bits. Therefore, the error correction coding device can generate a plurality of pulse amplitude modulation symbols while suppressing an increase in the operation amount of the soft decision error correction coding processing.

Note that, in the present disclosure, any component of the embodiment can be modified, or any component of the embodiment can be omitted.

INDUSTRIAL APPLICABILITY

The present disclosure is suitable for an error correction coding device and an error correction coding method.

REFERENCE SIGNS LIST

1: probability shaping coding unit, 2: hard decision error correction coding unit, 3: exclusive OR operating unit, 4: soft decision error correction coding unit, 5: symbol generating unit, 11: probability shaping coding circuit, 12: hard decision error correction coding circuit, 13: exclusive OR operating circuit, 14: soft decision error correction coding circuit, 15: symbol generating circuit, 21: memory, 22: processor

**Claims**

1. An error correction coding device comprising:

   an exclusive OR operating unit to acquire a plurality of information bit strings that are labels of respective multilevel modulation symbols from a frame in which a plurality of information bit strings that are labels of the plurality of multilevel modulation symbols are arranged, and operate an exclusive OR of a plurality of information bits that are labels of the respective multilevel modulation symbols; and
   a soft decision error correction coding unit to generate soft decision error correction redundancy bits by performing soft decision error correction coding on a plurality of operation results of the exclusive OR by the exclusive OR operating unit.

2. The error correction coding device according to claim 1, comprising:

   a hard decision error correction coding unit to acquire the plurality of information bit strings that are the labels of respective multilevel modulation symbols from the frame and generate hard decision error correction redundancy bits by performing hard decision error correction coding on the plurality of information bits, and
   a symbol generating unit to generate a plurality of pulse amplitude modulation symbols from a part of the labels of the respective multilevel modulation symbols or all of the labels of the respective multilevel modulation symbols, the hard decision error correction redundancy bits, and the soft decision error correction redundancy bits.

3. The error correction coding device according to claim 2, wherein

   a first dummy bit or a second dummy bit is included in a most significant bit of an information bit string that is a label of a part of multilevel modulation symbols among the plurality of multilevel modulation symbols, and
   the hard decision error correction coding unit includes,
   in the most significant bit including the first dummy bit, the hard decision error correction redundancy bits instead of the first dummy bit, and
   the soft decision error correction coding unit includes,
   in the most significant bit including the second dummy bit, the soft decision error correction redundancy bits instead of the second dummy bit.

4. The error correction coding device according to claim 3, wherein

   the frame includes

      a first group including a multilevel modulation symbol in which neither the first dummy bit nor the second dummy bit is included in the most significant bit or a label of the multilevel modulation symbol, and a multilevel modulation symbol in which the first dummy bit is included in the most significant bit or a label of the multilevel modulation symbol, and
      a second group including a multilevel modulation symbol in which the second dummy bit is included in the most significant bit or a label of the multilevel modulation symbol, and

   the exclusive OR operating unit

      operates an exclusive OR of a plurality of information bits that are labels of the respective multilevel modulation symbols included in the first group, and
      operates an exclusive OR of a plurality of information bits that are labels of T (T is an integer equal to or more than 1) multilevel modulation symbols included in the second group.

5. The error correction coding device according to claim 3, wherein

   when a dimension of each of a plurality of bits that are labels of respective multilevel modulation symbols is D (D is an integer equal to or more than 1), and a number of bits of each of the multilevel modulation symbols is D × M (M is an integer equal to or more than 2), the symbol generating unit generates each of the pulse amplitude modulation symbols by performing reflection binary gray coding on D × M bits included in each of the multilevel modulation symbols.

6. The error correction coding device according to claim 2, comprising a probability shaping coding unit to perform probability shaping coding on a first bit string to be communicated, and output a frame in which the plurality of information bit strings is arranged to the hard decision error correction coding unit, the information bit strings each being a second bit string that is the first bit string after the probability shaping coding as an information bit string.

7. An error correction coding method comprising:

   acquiring, by an exclusive OR operating unit, a plurality of information bit strings that are labels of respective multilevel modulation symbols from a frame in which a plurality of information bit strings that are labels of the plurality of multilevel modulation symbols are arranged, and operating an exclusive OR of a plurality of information bits that are labels of the respective multilevel modulation symbols; and
   generating, by a soft decision error correction coding unit, soft decision error correction redundancy bits by performing soft decision error correction coding on a plurality of operation results of the exclusive OR by the exclusive OR operating unit.

# FIG. 1

# FIG. 2

| Probability Shaping Coding Circuit ⟨11 | Hard Decision Error Correction Coding Circuit ⟨12 | Exclusive OR Operating Circuit ⟨13 |

| Soft Decision Error Correction Coding Circuit ⟨14 | Symbol Generating Circuit ⟨15 |

# FIG. 3

| Memory ⟨21 | Processor ⟨22 |

# FIG. 4

```
         ┌─────────┐
         │  START  │
         └─────────┘
              │
              ▼                        ⌐ST1
┌─────────────────────────────────────┐
│       Probability Shaping Coding Unit │
│    Generates Frame in Such Manner That│
│          Occurrence Probability of    │
│     Plurality of Signal Points Is Biased│
└─────────────────────────────────────┘
              │
              ▼                        ⌐ST2
┌─────────────────────────────────────┐
│  Hard Decision Error Correction Coding Unit│
│      Generates Hard Decision Error    │
│       Correction Redundancy Bits      │
└─────────────────────────────────────┘
              │
              ▼                        ⌐ST3
┌─────────────────────────────────────┐
│        Exclusive OR Operating Unit    │
│         Operates Exclusive OR of      │
│        Plurality of Information Bits   │
└─────────────────────────────────────┘
              │
              ▼                        ⌐ST4
┌─────────────────────────────────────┐
│  Soft Decision Error Correction Coding Unit│
│      Generates Soft Decision Error    │
│       Correction Redundancy Bits      │
└─────────────────────────────────────┘
              │
              ▼                        ⌐ST5
┌─────────────────────────────────────┐
│          Symbol Generating Unit       │
│           Generates Plurality of      │
│    Pulse Amplitude Modulation Symbols │
└─────────────────────────────────────┘
              │
              ▼
         ┌─────────┐
         │   END   │
         └─────────┘
```

# FIG. 5A

# FIG. 5B

# FIG. 6A

| (i, j) | g = 1 | g = 2 | g = 1 | g = 2 |
|---|---|---|---|---|
| **MSB** (1, 1) | B[1][1][1][1:N1] | HD-FEC Reserved Area / SD-FEC Reserved Area | B[1][1][1][1:N1] | HD-FEC Reserved Area / SD-FEC Reserved Area |
| (1, 2) | B[1][2][1][1:N1] | | B[1][2][1][1:N1] | |
| **SSB** (2, 1) | B[2][1][1][1:N2] | B[2][1][2][N2+1:N3] | B[2][1][1][1:N2] | B[2][1][2][N2+1:N3] |
| (2, 2) | B[2][2][1][1:N2] | B[2][2][2][N2+1:N3] | B[2][2][1][1:N2] | B[2][2][2][N2+1:N3] |
| **LSB** (3, 1) | B[3][1][1][1:N2] | B[3][1][2][N2+1:N3] | B[3][1][1][1:N2] | B[3][1][2][N2+1:N3] |
| (3, 2) | B[3][2][1][1:N2] | B[3][2][2][N2+1:N3] | B[3][2][1][1:N2] | B[3][2][2][N2+1:N3] |

... 

# FIG. 6B

| (i, j) | g = 1 | g = 2 | g = 1 | g = 2 |
|---|---|---|---|---|
| **MSB** (1, 1) | B[1][1][1][1:N1] | B[1][1:2][1][N1+1:N2] / SD-FEC Reserved Area | B[1][1][1][1:N1] | B[1][1:2][1][N1+1:N2] / SD-FEC Reserved Area |
| (1, 2) | B[1][2][1][1:N1] | | B[1][2][1][1:N1] | |
| **SSB** (2, 1) | B[2][1][1][1:N2] | B[2][1][2][N2+1:N3] | B[2][1][1][1:N2] | B[2][1][2][N2+1:N3] |
| (2, 2) | B[2][2][1][1:N2] | B[2][2][2][N2+1:N3] | B[2][2][1][1:N2] | B[2][2][2][N2+1:N3] |
| **LSB** (3, 1) | B[3][1][1][1:N2] | B[3][1][2][N2+1:N3] | B[3][1][1][1:N2] | B[3][1][2][N2+1:N3] |
| (3, 2) | B[3][2][1][1:N2] | B[3][2][2][N2+1:N3] | B[3][2][1][1:N2] | B[3][2][2][N2+1:N3] |

...

EP 4 557 620 A1

# FIG. 7A

| (i, j) | g = 1 | g = 2 | g = 1 | g = 2 |
|---|---|---|---|---|
| (1, 1) MSB | B[1][1][1][1:N2] | SD-FEC Reserved Area | B[1][1][1][1:N2] | SD-FEC Reserved Area |
| (1, 2) | B[1][2][1][1:N2] | | B[1][2][1][1:N2] | |
| (2, 1) SSB | B[2][1][1][1:N2] | B[2][1][2][N2+1:N3] | B[2][1][1][1:N2] | B[2][1][2][N2+1:N3] |
| (2, 2) | B[2][2][1][1:N2] | B[2][2][2][N2+1:N3] | B[2][2][1][1:N2] | B[2][2][2][N2+1:N3] |
| (3, 1) LSB | B[3][1][1][1:N2] | B[3][1][2][N2+1:N3] | B[3][1][1][1:N2] | B[3][1][2][N2+1:N3] |
| (3, 2) | B[3][2][1][1:N2] | B[3][2][2][N2+1:N3] | B[3][2][1][1:N2] | B[3][2][2][N2+1:N3] |

· · ·

# FIG. 7B

| (i, j) | g = 1 | g = 2 | g = 1 | g = 2 |
|---|---|---|---|---|
| (1, 1) MSB | B[1][1][1][1:N2] | SD-FEC Reserved Area | B[1][1][1][1:N2] | SD-FEC Reserved Area |
| (1, 2) | B[1][2][1][1:N2] | | B[1][2][1][1:N2] | |
| (2, 1) SSB | B[2][1][1][1:N2] | B[2][1][2][N2+1:N3] | B[2][1][1][1:N2] | B[2][1][2][N2+1:N3] |
| (2, 2) | B[2][2][1][1:N2] | B[2][2][2][N2+1:N3] | B[2][2][1][1:N2] | B[2][2][2][N2+1:N3] |
| (3, 1) LSB | B[3][1][1][1:N2] | B[3][1][2][N2+1:N3] | B[3][1][1][1:N2] | B[3][1][2][N2+1:N3] |
| (3, 2) | B[3][2][1][1:N2] | B[3][2][2][N2+1:N3] | B[3][2][1][1:N2] | B[3][2][2][N2+1:N3] |

· · ·

| SPB[1:N2] | | SPB[1:N2] | |
|---|---|---|---|

SPB[N2+1:N4]          SPB[N2+1:N4]

EP 4 557 620 A1

# FIG. 8

EP 4 557 620 A1

EP 4 557 620 A1

## FIG. 9A

| (i, j) | g = 1 | g = 2 | g = 1 | g = 2 |
|---|---|---|---|---|
| (1, 1) | B[1][1][1][1:N2] | SD-FEC Reserved Area | B[1][1][1][1:N2] | SD-FEC Reserved Area |
| MSB (1, 2) | B[1][2][1][1:N2] | | B[1][2][1][1:N2] | |
| (2, 1) | B[2][1][1][1:N2] | B[2][1][2][N2+1:N3] | B[2][1][1][1:N2] | B[2][1][2][N2+1:N3] |
| SSB (2, 2) | B[2][2][1][1:N2] | B[2][2][2][N2+1:N3] | B[2][2][1][1:N2] | B[2][2][2][N2+1:N3] |
| (3, 1) | B[3][1][1][1:N2] | B[3][1][2][N2+1:N3] | B[3][1][1][1:N2] | B[3][1][2][N2+1:N3] |
| LSB (3, 2) | B[3][2][1][1:N2] | B[3][2][2][N2+1:N3] | B[3][2][1][1:N2] | B[3][2][2][N2+1:N3] |

SPB[1:N4]   SPB[1:N4]

$N4 \leqq N3$

## FIG. 9B

| (i, j) | g = 1 | g = 2 | g = 1 | g = 2 |
|---|---|---|---|---|
| (1, 1) | B[1][1][1][1:N2] | B[1][1:2][2][N2+1:N3] | B[1][1][1][1:N2] | B[1][1:2][2][N2+1:N3] |
| MSB (1, 2) | B[1][2][1][1:N2] | | B[1][2][1][1:N2] | |
| (2, 1) | B[2][1][1][1:N2] | B[2][1][2][N2+1:N3] | B[2][1][1][1:N2] | B[2][1][2][N2+1:N3] |
| SSB (2, 2) | B[2][2][1][1:N2] | B[2][2][2][N2+1:N3] | B[2][2][1][1:N2] | B[2][2][2][N2+1:N3] |
| (3, 1) | B[3][1][1][1:N2] | B[3][1][2][N2+1:N3] | B[3][1][1][1:N2] | B[3][1][2][N2+1:N3] |
| LSB (3, 2) | B[3][2][1][1:N2] | B[3][2][2][N2+1:N3] | B[3][2][1][1:N2] | B[3][2][2][N2+1:N3] |

# FIG. 10A

| (i, j) | | |
|---|---|---|
| (1, 1) MSB | B[1][1][1:N3] | B[1][1][1:N3] |
| (1, 2) | B[1][2][1:N3] | B[1][2][1:N3] |
| (2, 1) SSB | B[2][1][1:N3] | B[2][1][1:N3] |
| (2, 2) | B[2][2][1:N3] | B[2][2][1:N3] |
| (3, 1) LSB | B[3][1][1:N3] | B[3][1][1:N3] |
| (3, 2) | B[3][2][1:N3] | B[3][2][1:N3] |

· · ·

# FIG. 10B

| j | | |
|---|---|---|
| 1 | X[1][1:N3] | X[1][1:N3] |
| 2 | X[2][1:N3] | X[2][1:N3] |

· · ·

EP 4 557 620 A1

## FIG. 11A

| | | Real Part | | | | | | | |
|---|---|---|---|---|---|---|---|---|---|
| | | -7 | -5 | -3 | -1 | 1 | 3 | 5 | 7 |
| Imaginary Part | 7 | 110 010 | 111 010 | 101 010 | 100 010 | 000 010 | 001 010 | 011 010 | 010 010 |
| | 5 | 110 011 | 111 011 | 101 011 | 100 011 | 000 011 | 001 011 | 011 011 | 010 011 |
| | 3 | 110 001 | 111 001 | 101 001 | 100 001 | 000 001 | 001 001 | 011 001 | 010 001 |
| | 1 | 110 000 | 111 000 | 101 000 | 100 000 | 000 000 | 001 000 | 011 000 | 010 000 |
| | -1 | 110 100 | 111 100 | 101 100 | 100 100 | 000 100 | 001 100 | 011 100 | 010 100 |
| | -3 | 110 101 | 111 101 | 101 101 | 100 101 | 000 101 | 001 101 | 011 101 | 010 101 |
| | -5 | 110 111 | 111 111 | 101 111 | 100 111 | 000 111 | 001 111 | 011 111 | 010 111 |
| | -7 | 110 110 | 111 110 | 101 110 | 100 110 | 000 110 | 001 110 | 011 110 | 010 110 |

## FIG. 11B

| | | Real Part | | | | | | | |
|---|---|---|---|---|---|---|---|---|---|
| | | -7 | -5 | -3 | -1 | 1 | 3 | 5 | 7 |
| Imaginary Part | 7 | 1 | 0 | 1 | 0 | 1 | 0 | 1 | 0 |
| | 5 | 0 | 1 | 0 | 1 | 0 | 1 | 0 | 1 |
| | 3 | 1 | 0 | 1 | 0 | 1 | 0 | 1 | 0 |
| | 1 | 0 | 1 | 0 | 1 | 0 | 1 | 0 | 1 |
| | -1 | 1 | 0 | 1 | 0 | 1 | 0 | 1 | 0 |
| | -3 | 0 | 1 | 0 | 1 | 0 | 1 | 0 | 1 |
| | -5 | 1 | 0 | 1 | 0 | 1 | 0 | 1 | 0 |
| | -7 | 0 | 1 | 0 | 1 | 0 | 1 | 0 | 1 |

EP 4 557 620 A1

# INTERNATIONAL SEARCH REPORT

| | International application No. |
| --- | --- |
| | **PCT/JP2022/031969** |

| A. | CLASSIFICATION OF SUBJECT MATTER |
| --- | --- |

*H03M 13/25*(2006.01)i; *H03M 13/29*(2006.01)i
FI:   H03M13/25; H03M13/29

According to International Patent Classification (IPC) or to both national classification and IPC

| B. | FIELDS SEARCHED |
| --- | --- |

Minimum documentation searched (classification system followed by classification symbols)

H03M13/25; H03M13/29

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2021-44681 A (FUJITSU LTD.) 18 March 2021 (2021-03-18)<br>paragraphs [0002], [0031], [0032], [0039], [0069]-[0098], [0106]-[0148], [0231]-[0256], fig. 1, 2, 8-10, 18, 19 | 1-4, 6, 7 |
| A | 吉田 剛 他, マルチレベル符号化圧縮PSによる光通信システムの低電力化, 電子情報通信学会 2021年総合大会講演論文集 通信2, 2021, page 188, B-10-30, (Proceedings of the 2021 IEICE General Conference, Communication 2.), non-official translation (YOSHIDA, Tsuyoshi et al. Low-power optical communication systems using multilevel encoded compressed PS.)<br>page 188 | 1-7 |
| A | KAKIZAKI, T. et al. Low-complexity Channel-polarized Multilevel Coding for Probabilistic Amplitude Shaping. 2022 Optical Fiber Communications Conference and Exhibition (OFC). March 2022, W3H.4<br>sections 1, 2 | 1-7 |

| ☐ Further documents are listed in the continuation of Box C. | ☑ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **25 October 2022** | **01 November 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/031969**

| Patent document cited in search report | | | Publication date (day/month/year) | Patent family member(s) | Publication date (day/month/year) |
|---|---|---|---|---|---|
| JP | 2021-44681 | A | 18 March 2021 | US 2021/0075515 A1 paragraphs [0003], [0043], [0044], [0052], [0082]-[0113], [0121]-[0163], [0247]-[0272], fig. 1, 2, 8-10, 18, 19 CN 112564857 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **K. SUGITANI et al.** Partial multilevel coding with probabilistic shaping for low-power optical transmission. *Proc. OECC/PSC*, 2019
- **R. BOSE** ; **D. RAY-CHAUDHURI**. On a class of error correcting binary group codes. *Information and Control*, March 1960, vol. 3 (1), 68-79
- **B.P. SMITH et al.** Staircase codes:FEC for 100 Gb/s OTN. *J. Lightw. Technol.*, January 2012, vol. 30 (1), 110-117
- **A.Y. SUKMADJI et al.** Zipper codes: Spatially-coupled product-like codes with iterative algebraic decoding. *Canadian Workshop on Information Theory (CWIT), Hamilton, ON, Canada*, June 2019, 1-6